# EUROPÄISCHE PATENTSCHRIFT

(11) **EP 1 051 888 B1**
(45) Veröffentlichungstag und Bekanntmachung des Hinweises auf die Patenterteilung: **27.03.2002**
(21) Anmeldenummer: 99908756.2
(22) Anmeldetag: 25.01.1999
(51) Int. Cl.: H05K 3/38

(54) **LÖSUNG UND VERFAHREN ZUM VORBEHANDELN VON KUPFEROBERFLÄCHEN**
PROCESS AND SOLUTION FOR THE PRELIMINARY TREATMENT OF COPPER SURFACES
SOLUTION ET PROCEDE DESTINES AU PRETRAITEMENT DE SURFACES DE CUIVRE

(30) Priorität: 03.02.1998 DE 19806190; 26.06.1998 DE 19830038
(43) Veröffentlichungstag der Anmeldung: 15.11.2000
(73) Patentinhaber: ATOTECH Deutschland GmbH, 10553 Berlin (DE)
(72) Erfinder: GRIESER, Udo, D-13599 Berlin (DE); MEYER, Heinrich, D-14109 Berlin (DE)
(74) Vertreter: Effert, Bressel und Kollegen
(86) Internationale Anmeldenummer: DE9900243
(87) Internationale Veröffentlichungsnummer: WO9940764

(56) Entgegenhaltungen:
- EP-A- 0 670 379
- WO-A-96/19097
- US-A- 3 645 772
- PATENT ABSTRACTS OF JAPAN vol. 96, no. 8, 30. August 1996 & JP 08 097559 A (OKUNO CHEM IND CO), 12. April 1996 in der Anmeldung erwähnt

## Beschreibung

Die Erfindung betrifft eine Lösung und ein Verfahren zum Vorbehandeln von Kupferoberflächen zum nachfolgenden Bilden eines haftfesten Verbundes zwischen den vorbehandelten Kupferoberflächen und Kunststoffsubstraten. Die Lösung dient vorzugsweise zum Vorbehandeln von Kupferschichten aufweisenden Leiterplatteninnenlagen zum Zweck der nachfolgenden Bildung eines haftfesten Verbundes zwischen den Leiterplatteninnenlagen und Leiterplatten-Kunstharzinnenlagen sowie zum Vorbehandeln von Kupferschichten aufweisenden Leiterplatten zum haftfesten Verbinden der Kupferschichten mit aus Kunststoffen bestehenden Resisten.

Bei der Herstellung von Leiterplatten werden verschiedene Teilprozesse durchgeführt, bei denen Kupferoberflächen haftfest an ein organisches Substrat gebunden werden müssen. In einigen Fällen muß die geforderte Haftfestigkeit der gebildeten Verbindungen auch über einen sehr langen Zeitraum gewährleistet sein. In anderen Fällen muß eine haftfeste Verbindung nur zeitweilig bestehen, beispielsweise wenn das organische Substrat nur während des Herstellprozesses der Leiterplatte auf den Kupferoberflächen verbleibt. Beispielsweise muß die haftfeste Verbindung von Trockenfilmresisten, die zur Strukturierung der Leiterzüge auf Leiterplatten dienen, mit den Kupferoberflächen nur während des Leiterplattenherstellverfahrens gewährleistet sein. Nach der Bildung der Leiterzugstrukturen können die Resiste wieder entfernt werden.

Die einfachste Möglichkeit zur Erhöhung der Haftfestigkeit besteht darin, die Kupferoberflächen vor dem Bilden der Verbindung anzuätzen und dabei aufzurauhen. Hierzu werden Mikroätzlösungen, beispielsweise schwefelsaure Lösungen von Wasserstoffperoxid oder Natriumperoxodisulfat, verwendet.

Ein weiteres Verfahren ist in US-A-3,645,772 beschrieben. Danach wird eine Vorbehandlungslösung für die Kupferoberflächen verwendet, die beispielsweise 5-Aminotetrazol enthält.

Eine Langzeitstabilität ist insbesondere beim Laminierprozeß für Mehrlagenleiterplatten erforderlich. Für diese Zwecke sind andere Vorbehandlungsverfahren für die Kupferoberflächen erförderlich.

Bei der Herstellung von Mehrlagenleiterplatten werden mehrere Leiterplatteninnenlagen zusammen mit isolierenden Kunstharzlagen (sogenannte prepregs: mit Glasfasernetzen verstärkte Epoxidharzfolien) laminiert. Der innere Zusammenhalt eines Laminats muß während der gesamten Lebensdauer der Leiterplatte aufrechterhalten bleiben. Hierzu müssen die auf den Innenlagen aufliegenden Kupferschichten, vorzugsweise die Leiterzugstrukturen, oberflächlich behandelt werden. Um dieses Problem zu lösen, wurden verschiedene Verfahren entwickelt.

Das für die Vorbehandlung vor Laminierverfahren üblicherweise angewendete Verfahren besteht darin, eine Oxidschicht auf den Kupferoberflächen zu bilden. Bei diesem als Schwarz- oder Braunoxidverfahren bekannten Prozeß werden sehr aggressive Reaktionsbedingungen zur Oxidbildung eingestellt. Ein Nachteil des Verfahrens besteht darin, daß die die Haftfestigkeit zur Kunstharzlage vermittelnde Oxidschicht nur eine geringe Beständigkeit gegen saure, insbesondere salzsaure, Behandlungslösungen aufweist, so daß sie bei Nachfolgeprozessen zur Metallisierung der Durchgangsbohrungen in Leiterplatten angegriffen und der Haftverbund unter Bildung von Delaminationen an den angegriffenen Stellen wieder aufgehoben wird (pink ring-Phänomen: von außen sichtbarer Angriff der Schwarzoxidschicht in unmittelbarer Umgebung eines Loches in Leiterplatten durch Verfärbung der ursprünglich schwarzen Oxidschicht, bei der die rosafarbene Kupferschicht der Innenlage als ringförmiger Defekt erkennbar wird; wedge void-Phänomen: in einem durch eine behandelte Bohrung in Leiterplatten angefertigten Querschliff erkennbarer Defekt in Form einer Spaltbildung zwischen einer Kupferinnenlage und dem angrenzenden Leiterplattenharz durch den Angriff von sauren Behandlungslösungen auf die Schwarzoxidschicht).

Eine Lösung des vorstehend beschriebenen Problems besteht darin, die Oxidschicht vor dem Laminierprozeß oberflächlich zu reduzieren. Das reduzierte Schwarzoxid weist gegenüber den bei der Durchkontaktierung der Durchgangslöcher verwendeten Chemikalien eine höhere Stabilität auf als normales Schwarzoxid. Durch den zusätzlichen Reduktionsschritt werden jedoch erhebliche Kosten verursacht. Zudem sind die für die Reduktionsbehandlung verwendbaren Chemikalien gegen Oxidation durch Luft wenig beständig, so daß die Standzeit der Bäder und die Haltbarkeit der Ergänzungschemikalien begrenzt sind. Dieses Problem soll nach JP-A-08097559 dadurch behoben werden, daß die reduzierten Kupferoxidschichten anschließend mit einer Schutzschicht versehen werden, indem diese mit einer wäßrigen Lösung behandelt werden, in der eine Aminothiazol- und/oder Aminobenzothiazol-Verbindung enthalten ist. Jedoch können damit zum einen das Kostenproblem der teuren Reduktionschemikalien und deren mangelnde Oxidationsbeständigkeit und zum anderen auch die Säureinstabilität der Schicht nicht vollständig behoben werden.

Eine andere Möglichkeit zur Haftvermittlung besteht darin, die Kupferoberflächen mit einer wäßrigen oder alkoholischen Lösung einer Azolverbindung zu behandeln. Ein derartiges Verfahren ist beispielsweise aus WO 96/19097 A1 bekannt. Danach werden die Kupferoberflächen mit einer Lösung behandelt, in der 0,1 bis 20 Gew.-% Wasserstoffperoxid, eine anorganische Säure, beispielsweise Schwefelsäure, ein organischer Korrosionsinhibitor, beispielsweise Benzotriazol, und ein Netzmittel enthalten sind. Durch die Ätzwirkung von Wasserstoffperoxid werden die Kupferoberflächen angeätzt, so daß mikrorauhe Oberflächen entstehen.

Auch aus US-A-4,917,758 sind Ätzlösungen bekannt, die jedoch zum Abdünnen von Kupferkaschierungen auf den Leiterplattenmaterialien dienen. In diesen Lösungen sind ebenfalls Wasserstoffperoxid, Schwefelsäure sowie eine Stickstoff enthaltende Verbindung, vorzugsweise Aminobenzoesäure, Aminotetrazol oder Phenylharnstoff, enthalten. Die aus WO-A-96 19097 bekannte Lösung enthält Wasserstoffperoxid, mindestens eine Säure, ein Triazol oder Tetrazol sowie ggf. als Stabilisator eine Sulfonsäure.

Der vorliegenden Erfindung liegt von daher das Problem zugrunde, die Nachteile des Standes der Technik zu vermeiden und insbesondere eine Vorbehandlungslösung und ein Verfahren bereitzustellen, um eine haftfeste Verbindung von Kupferoberflächen zu Kunststoffoberflächen zu ermöglichen. Das Verfahren soll einfach, sicher in der Handhabung und billig sein. Es ist ferner wichtig, daß durch Behandlung mit der Lösung auch eine Materialverbindung erhältlich ist, die bei Nachfolgeprozessen beim Herstellen von Leiterplatten, beispielsweise bei der Metallisierung von Durchgangsbohrungen im Leiterplattenmaterial, nicht zu Problemen führt (pink ring-, wedge void-Bildung). Vorzugsweise soll die Vorbehandlungslösung daher für die Anwendung beim Leiterplattenherstellverfahren einsetzbar sein.

Gelöst wird dieses Problem durch die Lösung gemäß Anspruch 1 und das Behandlungsverfahren gemäß Anspruch 18 sowie durch die Verwendung gemäß den Ansprüchen 19 und 20.

Die erfindungsgemäße Lösung dient zum Vorbehandeln von Kupferoberflächen zum nachfolgenden Bilden eines haftfesten Verbundes mit Kunststoffsubstraten und enthält
a. Wasserstoffperoxid,
b. mindestens eine Säure,
c. mindestens eine Stickstoff enthaltende, fünfgliedrige heterocyclische Verbindung, die kein Schwefel-, Selen- oder Telluratom im Heterocyclus aufweist, sowie
d. zusätzlich mindestens eine haftvermittelnde Verbindung aus der Gruppe, bestehend aus Sulfinsäuren, Seleninsäuren, Tellurinsäuren, heterocyclischen Verbidungen, die mindestens ein Schwefel-, Selen- und/oder Telluratom im Heterocyclus enthalten, sowie Sulfonium-, Selenonium- und Telluroniumsalzen, wobei die Sulfonium-, Selenonium- und Telluroniumsalze Verbindungen mit der allgemeinen Formel I sind 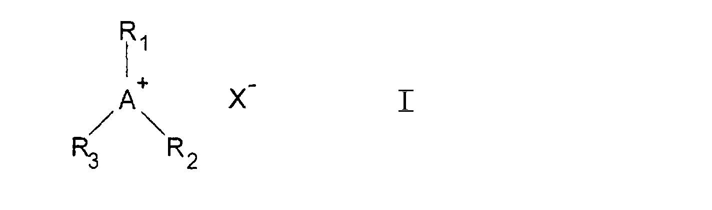 wobei A = S, Se oder Te,
   R₁, R₂ und R₃ = Alkyl, substituiertes Alkyl, Alkenyl, Phenyl, substituiertes Phenyl, Benzyl, Cycloalkyl, substituiertes Cycloalkyl, wobei R₁, R₂ und R₃ jeweils gleich oder unterschiedlich sind, und
   X⁻ = Anion einer anorganischen oder organischen Säure oder Hydroxid,
   mit der Maßgabe, daß die für Komponente b. ausgewählte Säure nicht mit den für Komponente d. ausgewählten Sulfin-, Selenin- oder Tellurinsäuren identisch ist.

Es sollen haftvermittelnde Verbindungen ausgewählt werden, die in der sauren, vorzugsweise schwefelsauren, Lösung eine ausreichende Löslichkeit aufweisen.

Zur Durchführung des erfindungsgemäßen Verfahrens werden die Kupferoberflächen mit der Lösung in Kontakt gebracht.

Das der Erfindung zugrunde liegende Problem wird insbesondere auch durch die Verwendungsmöglichkeiten der Lösung nach den Ansprüchen 19 und 20 gelöst. Danach dient die vorgenannte Lösung vorzugsweise zum Vorbehandeln von Kupferschichten aufweisenden Leiterplatteninnenlagen zum Bilden eines haftfesten Verbundes zwischen den Leiterplatteninnenlagen und Kunstharzlagen sowie zum Vorbehandeln von Kupferschichten aufweisenden Leiterplatten zum Bilden eines haftfesten Verbundes zwischen den Kupferschichten und aus Kunststoffen bestehenden Resisten.

Bevorzugte Ausführungsformen der Erfindung sind in den Unteransprüchen angegeben.

Bevorzugte Sulfinsäuren sind haftvermittelnde Verbindungen mit der chemischen Formel II 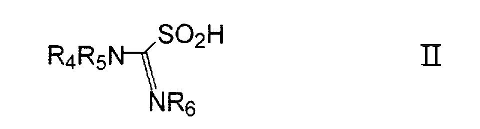
- mit R₄, R₅ und R₆ =: Wasserstoff, Alkyl, substituiertes Alkyl, Phenyl, substituiertes Phenyl oder R₇-(CO)- mit R₇ = Wasserstoff, Alkyl, substituiertes Alkyl, Phenyl oder substituiertes Phenyl, wobei R₄, R₅ und R₆ gleich oder unterschiedlich sein können,
und aromatische Sulfinsäuren.

Vorzugsweise ist Formamidinsulfinsäure als haftvermittelnde Verbindung in der Lösung enthalten. Als aromatische Sulfinsäuren können bevorzugt Benzolsulfinsäure, Toluolsulfinsäuren, Chlorbenzolsulfinsäuren, Nitrobenzolsulfinsäuren und Carboxybenzolsulfinsäuren eingesetzt werden.

Als haftvermittelnde heterocyclische Verbindungen können vorzugsweise auch Thiophene, Thiazole, Isothiazole, Thiadiazole und Thiatriazole eingesetzt werden.

Geeignete Thiophene sind Verbindungen mit der chemischen Formel III 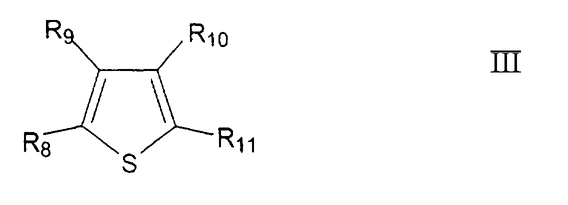
- mit R₈, R₉, R₁₀, R₁₁ =: Wasserstoff, Alkyl, substituiertes Alkyl, Phenyl, substituiertes Phenyl, Halogen, Amino, Alkylamino, Dialkylamino, Hydroxy. Alkoxy, Carboxy, Carboxyalkyl, Alkoxycarbonyl, Aminocarbonyl. R₁₂-CONH- mit R₁₂ = Wasserstoff, Alkyl, substituiertes Alkyl, Phenyl oder substituiertes Phenyl, wobei R₈, R₉, R₁₀ und R₁₁ gleich oder unterschiedlich und Teil von an den Thiophenring kondensierten homo- oder heterocyclischen Ringen sein können.

Besonders bevorzugte Thiophene sind Aminothiophencarbonsäuren, deren Ester und Amide. Beispielsweise kann 3-Aminothiophen-2-carbonsäuremethylester vorteilhaft eingesetzt werden.

Geeignete Thiazole sind Verbindungen mit der chemischen Formel IV: 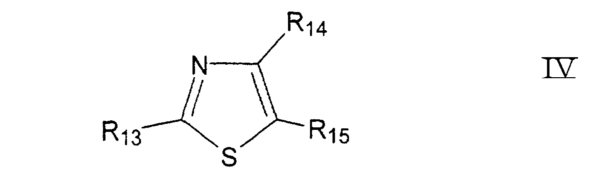
- mit R₁₃, R₁₄, R₁₅ =: Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R₁₆-CONH- mit R₁₆ = Wasserstoff, Alkyl, substituiertes Alkyl, Phenyl oder substituiertes Phenyl, wobei R₁₃, R₁₄ und R₁₅ gleich oder unterschiedlich und Teil eines an den Thiazolring kondensierten homo- oder heterocyclischen Ringes sein können.

Besonders geeignete Thiazole sind Aminothiazole sowie substituierte Aminothiazole. Ferner sind bevorzugte Thiadiazole haftvermittelnde Verbindungen aus der Gruppe, bestehend aus Aminothiadiazolen und substituierten Aminothiadiazolen.

Ferner werden als Sulfoniumsalze vorzugsweise Trimethylsulfonium-, Triphenylsulfonium-, Methioninalkylsulfonium- und Methioninbenzylsulfoniumsalze als haftvermittelnde Verbindungen eingesetzt.

Als Stickstoff enthaltende, fünfgliedrige heterocyclische Verbindungen, die kein Schwefel-, Selen- oder Telluratom im Heterocyclus enthalten, können monocyclische und polycyclische kondensierte Ringsysteme eingesetzt werden. Beispielsweise kann die Verbindung einen anellierten Benzol-, Naphthalin- oder Pyrimidinring enthalten. Für die Auswahl dieser Verbindungen ist zu beachten, daß diese in der sauren Lösung eine ausreichende Löslichkeit aufweisen sollen. Vorzugsweise sind Triazole, Tetrazole, Imidazole, Pyrazole und Purine bzw. deren Derivate in der Lösung enthalten.

Die Lösung enthält insbesondere Triazole mit der chemischen Formel Va 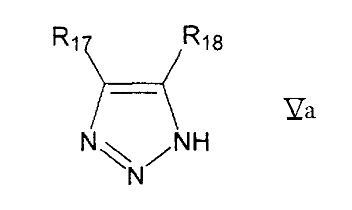
- mit R_{17,} R₁₈ =: Wasserstoff, Alkyl, substituiertes Alkyl, Amino, Phenyl, substituiertes Phenyl, Carboxyalkyl, wobei R₁₇ und R₁₈ gleich oder unterschiedlich und Teil eines an den Triazolring kondensierten homo- oder heterocyclischen Ringes sein können.

Besonders bevorzugt sind Benzotriazol, Methylbenzotriazol, Ethylbenzotriazol und Dimethylbenzotriazol.

Außerdem kann die Lösung Tetrazole mit der chemischen Formel Vb enthalten 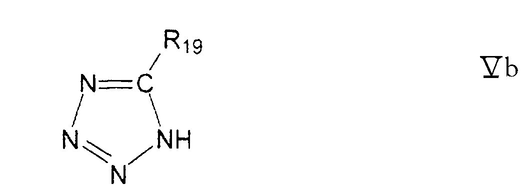
- mit R₁₉ =: Wasserstoff, Alkyl, substituiertes Alkyl, Halogenalkyl, Amino, Phenyl, substituiertes Phenyl, Benzyl, Carboxy, Carboxyalkyl, Alkoxycarbonyl, Aminocarbonyl, R₂₀-CONH mit R₂₀ = Wasserstoff, Alkyl, substituiertes Alkyl, Phenyl oder substituiertes Phenyl.

Als bevorzugte Tetrazolverbindung können 5-Aminotetrazol und 5-Phenyltetrazol eingesetzt werden. Als bevorzugte Imidazolverbindung kann Benzimidazol verwendet werden. 5-Aminotetrazol, 5-Phenyltetrazol, Benzotriazol, Methylbenzotriazol und Ethylbenzotriazol sind insbesondere wegen deren guter Löslichkeit in der Vorbehandlungslösung und wegen der leichten Verfügbarkeit bevorzugte Verbindungen.

Bevorzugte Kombinationen sind Benzotriazol, Methylbenzotriazol, Ethylbenzotriazol, 5-Aminotetrazol und 5-Phenyltetrazol als Stickstoff enthaltende heterocyclische Verbindungen mit Aminothiophencarbonsäuren, deren Estern und Amiden, Aminothiazolen und substituierten Aminothiazolen als heterocyclische Verbindungen.

Das erfindungsgemäße Verfahren stellt eine außerordentlich einfache Vorbehandlung von Kupferoberflächen für die nachfolgende haftfeste Verbindung mit Kunststoffen sicher. Im wesentlichen ist lediglich ein Verfahrensschritt erforderlich, nämlich die Behandlung der Kupferoberflächen mit der erfindungsgemäßen Lösung zur nachfolgenden Bildung eines Verbundes mit organischen Substraten. Die Haftfestigkeit sinkt auch nach langer Zeit nicht ab. Sind die haftvermittelnden Verbindungen in der Lösung nicht enthalten, kann keine annähernd so hohe Haftfestigkeit des Verbundes erreicht werden. Außerdem ist die Langzeitstabilität des Verbundes nach Vorbehandlung mit einer Lösung, die die erfindungsgemäßen haftvermittelnden Verbindungen nicht enthält, wesentlich schlechter als nach Verwendung einer Lösung, die die haftvermittelnden Verbindungen enthält.

Darüber hinaus werden die im Zusammenhang mit der Metallisierung von Durchgangslöchern in Leiterplatten entstehenden Probleme, nämlich die Bildung von pink ring und wedge voids, durch den Einsatz dieser zusätzlichen Verbindungen in der Vorbehandlungslösung vermieden, da die mit der erfindungsgemäßen Lösung erzeugten haftvermittelnden Schichten eine ausgezeichnete Säurebeständigkeit aufweisen, während Black Oxide- (Schwarzoxid-) und reduzierte Black Oxide-Schichten gegen salzsaure Lösungen eine gewisse Empfindlichkeit aufweisen. Es hat sich sogar gezeigt, daß sich die Haftfestigkeit eines Verbundes mit organischen Substraten in bestimmten Fällen verbessern läßt, wenn die Kupferoberflächen nach dem Behandeln mit der erfindungsgemäßen Lösung und vor dem Herstellen des Verbundes mit verdünnter Säure behandelt werden. Vorzugsweise kann hierfür Salzsäure eingesetzt werden.

Die vorteilhafte Wirkung der erfindungsgemäßen Lösung war überraschend, da auch eine alleinige Verwendung der haftvermittelnden Verbindungen in der Vorbehandlungslösung nicht die erwünschte hohe Langzeit-Haftfestigkeit ergibt. Durch Anwendung beider Lösungsbestandteile verfärben sich die Kupferoberflächen und führen zu den gewünschten Eigenschaften.

Zur sicheren Vorbehandlung werden die Kupferoberflächen in der Regel zuerst gereinigt. Hierzu können alle herkömmlichen Reinigungslösungen verwendet werden. Üblicherweise werden Netzmittel und gegebenenfalls Komplexbildner, beispielsweise Triethanolamin, enthaltende wäßrige Lösungen eingesetzt.

Nach dem Spülen der gereinigten Kupferoberflächen können diese mit einer sogenannten Vortauchlösung in Kontakt gebracht werden, die eine der fünfgliedrigen heterocyclischen Verbindungen (Komponente c.) in Wasser gelöst enthält, vorzugsweise in einer Konzentration von 0,1 bis 10 g/l, besonders bevorzugt von 0,5 bis 2 g/l. Durch diese Behandlung wird die haftvermittelnde Schicht im nachfolgenden Behandlungsschritt in zuverlässigerer Weise gebildet. Insbesondere werden eventuelle Verzögerungen der Schichtbildung vermieden; die Schichtbildung startet in diesem Falle unmittelbar mit dem In-Kontakt-Bringen der Oberflächen mit der erfindungsgemäßen Lösung.

Anschließend werden die Oberflächen ohne weitere Spülung in der erfindungsgemäßen Lösung behandelt. Dabei verfärben sich die Kupferoberflächen unter Bildung einer haftvermittelnden Schicht von rosafarben in einen Braunton, je nach Art der eingesetzten Kombination von Stickstoff enthaltenden, fünfgliedrigen heterocyclischen und haftvermittelnden Verbindungen.

Durch die Mikroätzwirkung des Wasserstoffperoxids in Verbindung mit der Säure werden mikrorauhe Kupferoberflächen erhalten, die wegen der Oberflächenvergrößerung eine Erhöhung der Haftfestigkeit des nachfolgend gebildeten Verbundes zwischen den Kupferoberflächen und dem Kunststoffsubstrat ermöglicht. Die sich beim Behandeln ändernde Farbe der Oberflächen wird durch eine dünne Kupferoxidschicht hervorgerufen. Es wird außerdem vermutet, daß die Haftfestigkeit des nachfolgend gebildeten Verbundes zusätzlich durch die Bildung einer kupferorganischen Verbindung verbessert wird, die sich wahrscheinlich aus Kupfer bzw. Kupferoxid, der Stickstoff enthaltenden Verbindung und der haftvermittelnden Verbindung auf der Kupferoberfläche bildet. Als Säure ist in der erfindungsgemäßen Lösung vorzugsweise anorganische Säure, besonders bevorzugt Schwefelsäure, enthalten. Grundsätzlich sind aber auch andere Säuren einsetzbar.

Zur Stabilisierung von Wasserstoffperoxid gegen einen Zerfall kann die Lösung zusätzliche weitere Verbindungen, beispielsweise p-Phenolsulfonsäure, und als Lösungsmittel Wasser und zusätzlich organische Lösungsmittel, wie Alkohole, enthalten, beispielsweise um die Löslichkeit der darin enthaltenen Bestandteile, insbesondere der Stickstoff enthaltenden, fünfgliedrigen heterocyclischen Verbindungen und der haftvermittelnden Verbindungen, zu erhöhen.

Zusätzlich können auch weitere anorganische und organische Verbindungen in der Lösung enthalten sein, beispielsweise Kupfersulfat und Netzmittel.

Die Behandlung wird vorzugsweise bei einer Temperatur von 20 bis 60°C durchgeführt. Die Behandlungszeit beträgt bevorzugt 10 bis 600 Sekunden. Je höher die Temperatur eingestellt wird. desto schneller wirkt die Lösung. Daher können gegebenenfalls auch wesentlich kürzere Behandlungszeiten gewählt werden. Unter praktischen Gesichtspunkten wird jedoch vorzugsweise eine mittlere Temperatur gewählt, beispielsweise von 35 bis 45°C, um die Reaktion besser kontrollieren zu können. Mittlere Behandlungszeiten sind 20 bis 90 Sekunden. Außerdem kann sich wegen möglicher Inkompatibilitäten bestimmter Bestandteile der Lösung bei erhöhter Temperatur, beispielsweise wegen bei erhöhter Temperatur schlecht löslicher Netzmittel, das Erfordernis ergeben, eine obere Temperaturgrenze einzuhalten.

Die in der Lösung bevorzugt eingestellten Konzentrationsbereiche sind:

| | |
|---|---|
| Schwefelsäure, konz. | 10 bis 250 g/l |
| Wasserstoffperoxid, 30 Gew.-% | 1 bis 100 g/l |
| fünfgliedrige Stickstoff enthaltende heterocyclische Verbindungen | 0,5 bis 50 g/l |
| haftvermittelnde Verbindungen: Sulfin-, Selenin- oder Teilurinsäure | 0,05 bis 10 g/l |
| haftvermittelnde heterocyclische Verbindung | 0,05 bis 20 g/l |
| Sulfonium-, Selenonium- oder Telluroniumsalze | 0,01 bis 10 g/l |

Die optimale Konzentration der vorgenannten Badbestandteile hängt von der Art der eingesetzten Stickstoff enthaltenden, heterocyclischen Verbindungen und der haftvermittelnden Verbindungen ab.

Nach der Behandlung mit der erfindungsgemäßen Lösung werden die Kupferoberflächen wieder gespült, vorzugsweise mit warmem, deionisiertem Wasser. Anschließend werden sie getrocknet, beispielsweise mit heißer Luft.

Optional können die Kupferoberflächen nach dem Spülen mit verdünnter Säure behandelt werden, vorzugsweise mit 10 Gew.-% Salzsäure oder 10 Gew.-% Schwefelsäure. Behandlungszeiten von 5 Sekunden bis 300 Sekunden sind dabei zweckmäßig. Nach der Säurebehandlung werden die Kupferoberflächen erneut gespült. vorzugsweise mit deionisiertem Wasser.

Zur Erhöhung der Haltbarkeit der erfindungsgemäßen Lösung ist es günstig, die gebrauchsfertige Behandlungslösung kurz vor der Durchführung des Verfahrens anzusetzen. Beispielsweise kann Wasserstoffperoxid mit einer schwefelsauren Lösung der Stickstoff enthaltenden, heterocyclischen und der haftvermittelnden Verbindungen gemischt werden oder kurz vor dem Gebrauch eine bereits angesetzte Lösung ergänzt werden, um die gewünschten Konzentrationen der Einzelbestandteile einzustellen.

Die Behandlung der die Kupferoberflächen aufweisenden Werkstücke kann in üblichen Tauchanlagen durchgeführt werden. Bei der Behandlung von Leiterplatten hat es sich als besonders günstig herausgestellt, sogenannte Durchlaufanlagen einzusetzen, bei denen die Platten in einer horizontalen Transportbahn durch die Anlage geführt und dabei mit den Behandlungslösungen in Kontakt gebracht werden, indem die Platten durch ein Flüssigkeitsbett geführt werden, das durch am Anfang und am Ende der Behandlungsstrecke angeordnete Abquetschwatzen aufgestaut ist, und/oder indem die Platten über geeignete Düsen, beispielsweise Sprüh- oder Schwalldüsen, mit der Behandlungsflüssigkeit in Kontakt gebracht werden. Die Leiterplatten können hierzu horizontal oder vertikal oder in jeder beliebigen anderen Ausrichtung gehalten werden.

Die nachfolgenden Beispiele dienen zur weiteren Erläuterung der Erfindung:

### Beispiel 1:

Durch Vermischen folgender Bestandteile wurde eine wäßrige Lösung hergestellt:

| | |
|---|---|
| Schwefelsäure, 96 Gew.-% | 50 m |
| Wasserstoffperoxid, 30 Gew.-% in Wasser | 60 m |
| Benzotriazol | 10 g |
| Formamidinsulfinsäure | 0,5 g |
| Auffüllen mit deionisiertem Wasser auf 1 I. | |

Die Lösung wurde auf 40°C erhitzt, und eine Kupferfolie (Leiterplattenqualität, etwa 25 µm Dicke) wurde 60 sec lang in die Lösung eingetaucht. Nach der Behandlung wurde die Folie mit warmem deionisiertem Wasser gespült und anschließend getrocknet. Die Kupferfolie wies einen braunen Farbton auf.

Die Kupferfolie wurde danach auf ein prepreg (mit Glasfasernetz verstärkte Epoxidharzfolie (FR4-Harz), Type 2125 MT, Dicke 0,1 µm, von Firma Dielektra, DE) laminiert, indem die Kupfer- und die Prepregfolie bei einer Temperatur von 175°C bei einem Druck von 2,5·10⁶ Pa (Δ 25 Bar) zusammen verpreßt wurden.

Die Schälfestigkeit der Kupferfolie auf der Prepregfolie wurde gemessen. Es wurden Schälfestigkeitswerte von 9,9 bis 10,6 N/cm ermittelt.

### Beispiele 2 bis 10:

Beispiel 1 wurde jeweils mit einer Lösung wiederholt, die stets folgende Bestandteile aufwies:

| | |
|---|---|
| Schwefelsäure, 96 Gew.-% | 50 ml |
| Wasserstoffperoxid, 30 Gew.-% in Wasser | 60 ml |

und zusätzlich die in Tabelle 1 aufgeführten weiteren Bestandteile (heterocyclische S-, Se- und Te-freie Verbindung und haftvermittelnde Verbindung). Die hergestellten Mischungen wurden mit deionisiertem Wasser auf 1 l aufgefüllt.

Die nach Beispiel 2 behandelte Kupferfolie wies einen rötlichen Farbton auf. Die nach den Beispielen 3 bis 10 behandelten Kupferfolien wiesen einen braunen Farbton auf.

Die Schälfestigkeit wurde in jedem Falle wie nach Beispiel 1 gemessen. Es wurden die in Tabelle 1 angegebenen Werte für die Schälfestigkeit erhalten.

### Beispiel 11:

Eine Kupferfolie wurde wie in Beispiel 4 behandelt, jedoch wurde die Kupferfolie vor dem Laminieren bei Raumtemperatur 20 Sekunden lang mit 10 Gew.-% Salzsäure behandelt und anschließend mit deionisiertem Wasser gespült.

Es wurde eine Schälfestigkeit ähnlich der von Beispiel 1 erhalten (11,1 bis 11,6 N/cm).

### Vergleichsbeispiel:

Beispiel 1 wurde wiederholt, allerdings mit einer Lösung, in der keine der haftvermittelnden Verbindungen enthalten war.

Es wurde lediglich eine Schälfestigkeit von 3,6 bis 4,0 N/cm erhalten.

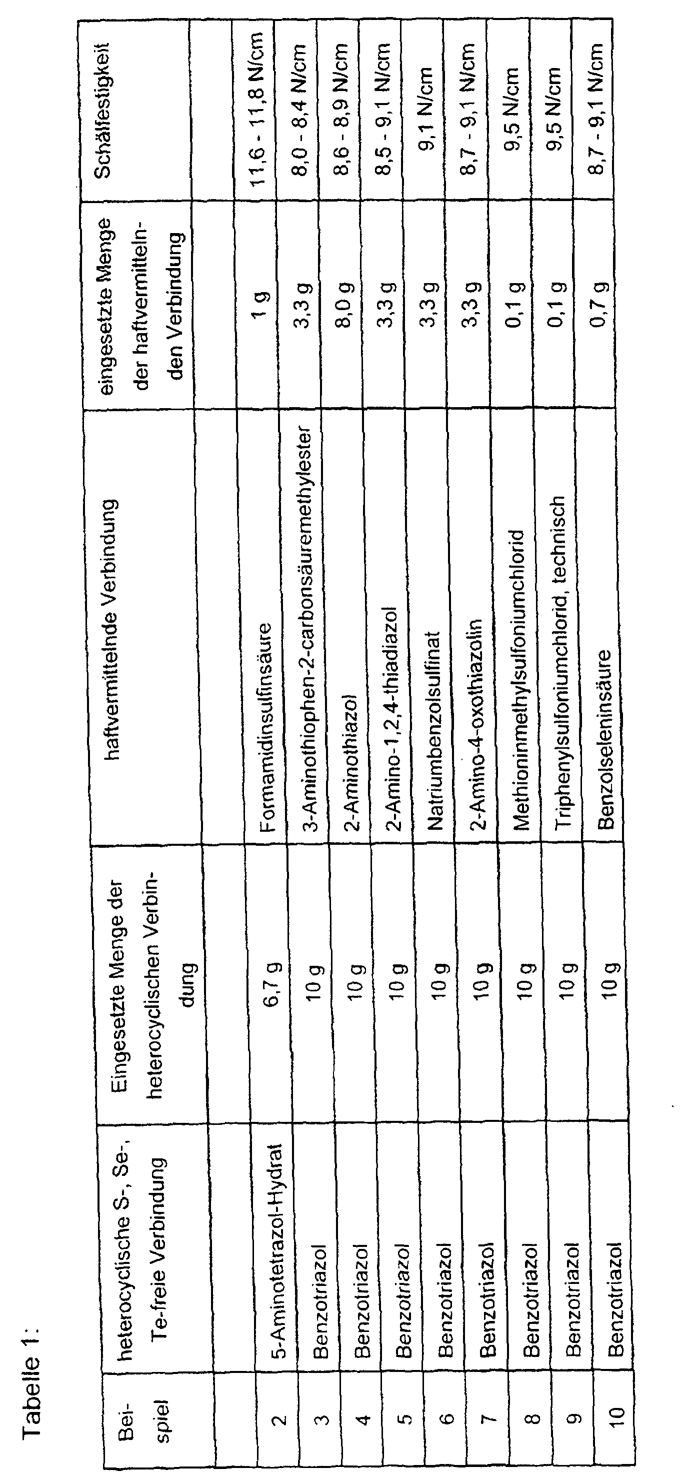

## Patentansprüche

1. Lösung zum Vorbehandeln von Kupferoberflächen zum nachfolgenden Bilden eines haftfesten Verbundes zwischen den Kupferoberflächen und Kunststoffsubstraten, enthaltend
a. Wasserstoffperoxid,
b. mindestens eine Säure und
c. mindestens eine Stickstoff enthaltende, fünfgliedrige heterocyclische Verbindung, die kein Schwefel-, Selen- oder Telluratom im Heterocyclus enthält,
**dadurch gekennzeichnet, daß**
d. zusätzlich mindestens eine haftvermittelnde Verbindung aus der Gruppe, bestehend aus Sulfinsäuren, Seleninsäuren, Tellurinsäuren, heterocyclischen Verbindungen, die mindestens ein Schwefel-, Selen- und/oder Telluratom im Heterocyclus enthalten, sowie Sulfonium-, Selenonium- und Telluroniumsalzen, enthalten ist, wobei die Sulfonium-, Selenonium- und Telluroniumsalze Verbindungen mit der allgemeinen Formel I sind 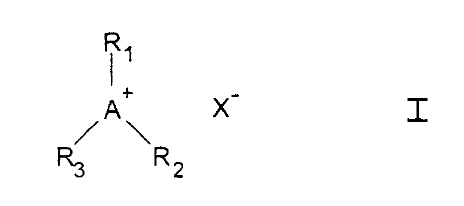 wobei A = S, Se oder Te,
R₁, R₂ und R₃ = Alkyl, substituiertes Alkyl, Alkenyl, Phenyl, substituiertes Phenyl, Benzyl, Cycloalkyl, substituiertes Cycloalkyl. wobei R₁, R₂ und R₃ gleich oder unterschiedlich sind, und
X⁻ = Anion einer anorganischen oder organischen Säure oder Hydroxid,
mit der Maßgabe, daß die für Komponente b. ausgewählte Säure nicht mit den für Komponente d. ausgewählten Sulfin-, Selenin- oder Tellurinsäuren identisch ist.

2. Lösung nach Anspruch 1, **dadurch gekennzeichnet, daß** Sulfinsäuren aus der Gruppe, bestehend aus aromatischen Sulfinsäuren und Verbindungen mit der chemischen Formel II 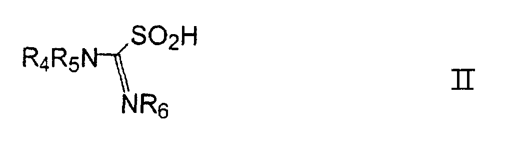
mit R₄, R₅ und R₆ = Wasserstoff, Alkyl, substituiertes Alkyl, Phenyl, substituiertes Phenyl, R₇-(CO)- mit R₇ = Wasserstoff, Alkyl, substituiertes Alkyl, Phenyl oder substituiertes Phenyl, wobei R₄, R₅ und R₆ gleich oder unterschiedlich sind,
enthalten sind.

3. Lösung nach einem der vorstehenden Ansprüche, **dadurch gekennzeichnet, daß** Formamidinsulfinsäure als haftvermittelnde Verbindung enthalten ist.

4. Lösung nach einem der Ansprüche 1 und 2, **dadurch gekennzeichnet, daß** aromatische Sulfinsäuren aus der Gruppe, bestehend aus Benzolsulfinsäure, Toluolsulfinsäuren, Chlorbenzolsulfinsäuren, Nitrobenzolsulfinsäuren und Carboxybenzolsulfinsäuren, enthalten sind.

5. Lösung nach einem der vorstehenden Ansprüche, **dadurch gekennzeichnet, daß** mindestens eine haftvermittelnde heterocyclische Verbindung aus der Gruppe, bestehend aus Thiophenen, Thiazolen, Isothiazolen, Thiadiazolen und Thiatriazolen, enthalten ist.

6. Lösung nach Anspruch 5, **dadurch gekennzeichnet, daß** mindestens ein Thiophen aus der Gruppe, bestehend aus Verbindungen mit der chemischen Formel III enthalten ist 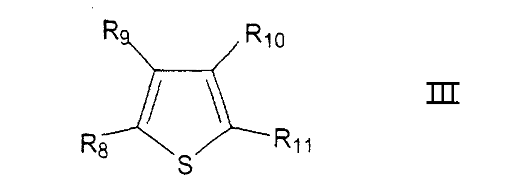
mit R₈, R₉, R₁₀, R₁₁ = Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R12-CONH- mit R₁₂ = Wasserstoff, Alkyl, substituiertes Alkyl, Phenyl oder substituiertes Phenyl, wobei R₈, R₉, R₁₀ und R₁₁ gleich oder unterschiedlich und Teil von an den Thiophenring kondensierten homo- oder heterocyclischen Ringen sein können.

7. Lösung nach einem der Ansprüche 5 und 6, **dadurch gekennzeichnet, daß** mindestens ein Thiophen aus der Gruppe, bestehend aus Aminothiophencarbonsäuren, deren Estern und deren Amiden, enthalten ist.

8. Lösung nach einem der Ansprüche 5 bis 7, **dadurch gekennzeichnet, daß** mindestens ein Thiazol aus der Gruppe, bestehend aus Verbindungen mit der chemischen Formel IV enthalten ist 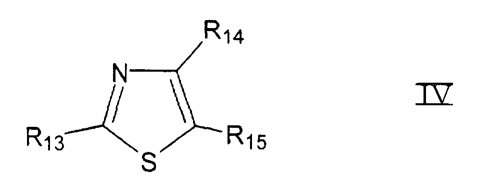
mit R₁₃, R₁₄, R₁₅ = Wasserstoff, Alkyl, substituiertes Alkyl, Phenyl, substituiertes Phenyl, Halogen, Amino, Alkylamino, Dialkylamino, Hydroxy, Alkoxy, Carboxy, Carboxyalkyl, Alkoxycarbonyl, Aminocarbonyl, R₁₆-CONH- mit R₁₆ = Wasserstoff, Alkyl, substituiertes Alkyl, Phenyl oder substituiertes Phenyl, wobei R₁₃, R₁₄ und R₁₅ gleich oder unterschiedlich und Teil eines an den Thiazolring kondensierten homo- oder heterocyclischen Ringes sein können.

9. Lösung nach einem der Ansprüche 5 bis 8, **dadurch gekennzeichnet, daß** mindestens ein Thiazol aus der Gruppe, bestehend aus Aminothiazolen und substituierten Aminothiazolen, enthalten ist.

10. Lösung nach einem der Ansprüche 5 bis 9, **dadurch gekennzeichnet, daß** mindestens ein Thiadiazol aus der Gruppe, bestehend aus Aminothiadiazolen und substituierten Aminothiadiazolen, enthalten ist.

11. Lösung nach einem der vorstehenden Ansprüche, **dadurch gekennzeichnet, daß** mindestens ein Sulfoniumsalz aus der Gruppe, bestehend aus Trimethylsulfoniumsalzen, Triphenylsulfoniumsalzen, Methioninalkylsulfoniumsalzen und Methioninbenzylsulfoniumsalzen, enthalten ist.

12. Lösung nach einem der vorstehenden Ansprüche, **dadurch gekennzeichnet, daß** mindestens eine Stickstoff enthaltende, fünfgliedrige heterocyclische Verbindung aus der Gruppe, bestehend aus Triazolen, Tetrazolen, Imidazolen, Pyrazolen und Purinen, enthalten ist.

13. Lösung nach Anspruch 12, **dadurch gekennzeichnet, daß** mindestens ein Triazol mit der chemischen Formel Va enthalten ist 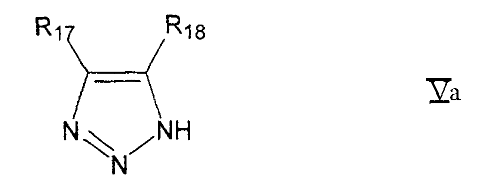
mit R_{17,} R₁₈ = Wasserstoff, Alkyl, substituiertes Alkyl, Amino, Phenyl, substituiertes Phenyl, Carboxyalkyl, wobei R₁₇ und R₁₈ gleich oder unterschiedlich und Teil eines an den Triazolring kondensierten homo- oder heterocyclischen Ringes sein können.

14. Lösung nach einem der Ansprüche 12 und 13, **dadurch gekennzeichnet, daß** mindestens ein Triazol aus der Gruppe, bestehend aus Benzotriazol, Methylbenzotriazol, Ethylbenzotriazol und Dimethylbenzotriazol, enthalten ist.

15. Lösung nach einem der Ansprüche 12 bis 14, **dadurch gekennzeichnet, daß** mindestens ein Tetrazol mit der chemischen Formel Vb enthalten ist 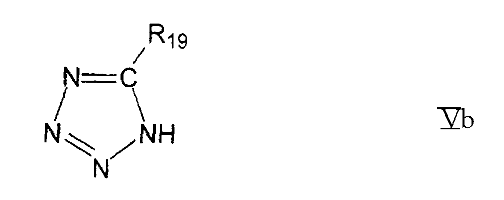
mit R₁₉ = Wasserstoff, Alkyl, substituiertes Alkyl, Halogenalkyl, Amino, Phenyl, substituiertes Phenyl, Benzyl, Carboxy, Carboxyalkyl, Alkoxycarbonyl, Aminocarbonyl oder R₂₀-CONH mit R₂₀ = Wasserstoff, Alkyl, substituiertes Alkyl, Phenyl oder substituiertes Phenyl.

16. Lösung nach einem der Ansprüche 12 bis 15, **dadurch gekennzeichnet, daß** mindestens ein Tetrazol aus der Gruppe, bestehend aus 5-Aminotetrazol und 5-Phenyltetrazol, enthalten ist.

17. Lösung nach einem der vorstehenden Ansprüche, **dadurch gekennzeichnet, daß** für Komponente b. in der Lösung Schwefelsäure als Säure enthalten ist.

18. Verfahren zum Vorbehandeln von Kupferoberflächen zum nachfolgenden Bilden eines haftfesten Verbundes der Kupferoberflächen mit Kunststoffsubstraten, bei dem die Kupferoberflächen mit der Lösung nach einem der Ansprüche 1 bis 17 in Kontakt gebracht werden.

19. Verwendung der Lösung nach einem der Ansprüche 1 bis 17 zum Vorbehandeln von Kupferschichten aufweisenden Leiterplatteninnenlagen zum Bilden eines haftfesten Verbundes zwischen den Leiterplatteninnenlagen und Kunstharzlagen.

20. Verwendung der Lösung nach einem der Ansprüche 1 bis 17 zum Vorbehandeln von Kupferschichten aufweisenden Leiterplatten zum Bilden eines haftfesten Verbundes zwischen den Kupferschichten und aus Kunststoffen bestehenden Resisten.

## Claims

1. Solution for the preliminary treatment of copper surfaces for the subsequent formation of a firmly adhesive bonding between the copper surfaces and plastics material substrates, containing
a. hydrogen peroxide,
b. at least one acid and
c. at least one nitrogen-containing, five-membered, heterocyclic compound which contains no sulphur atom, no selenium atom or tellurium atom in the heterocycle,
**characterised in that**
d. additionally at least one bonding compound is included from the group of sulphinic acids, selenic acids, telluric acids, heterocyclic compounds which contain at least one sulphur, selenium and/or tellurium atom in the heterocycle, as well as sulphonium, selenonium and telluronium salts, the sulphonium, selenonium and telluronium salts being compounds having the general formula I 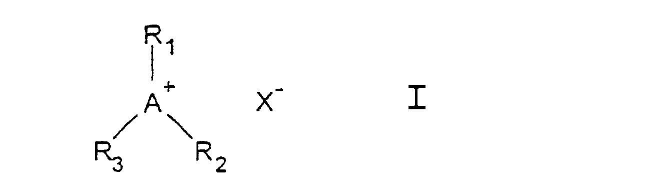 in which
A = S, Se or Te,
R₁, R₂ and R₃ = alkyl, substituted alkyl, alkenyl, phenyl, substituted phenyl, benzyl, cycloalkyl, substituted cycloalkyl, R₁, R₂ and R₃ being identical or different, and X⁻ = anion of an inorganic or organic acid or hydroxide,
with the proviso thon the acid, selected for component b., is not identical to the sulphinic, selenic or telluric acids selected for component d.

2. Solution according to claim 1, **characterised in that** sulphinic acids are included from the group of aromatic sulphinic acids and compounds having the chemical formula II 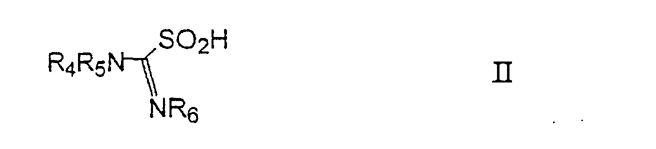 with R₄, R₅ and R₆ = hydrogen, alkyl, substituted alkyl, phenyl, substituted phenyl, R₇-(CO)- with R₇ = hydrogen, alkyl, substituted alkyl, phenyl or substituted phenyl, R₄, R₅ and R₆ being identical or different.

3. Solution according to one of the preceding claims, **characterised in that** formamidine sulphinic acid is included as the bonding compound.

4. Solution according to one of claims 1 and 2, **characterised in that** aromatic sulphinic acids are included from the group of benzene sulphinic acid, toluene sulphinic acids, chlorobenzene sulphinic acids, nitrobenzene sulphinic acids and carboxybenzene sulphinic acids.

5. Solution according to one of the preceding claims, **characterised in that** at least one bonding heterocyclic compound is included from the group of thiophenes, thiazols, isothiazols, thiadiazols and thiatriazols.

6. Solution according to claim 5, **characterised in that** at least one thiophene is included from the group of compounds having the chemical formula III 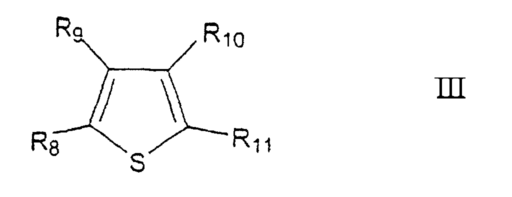
with R₈, R₉, R₁₀, R₁₁ = hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R₁₂-CONH- with R₁₂ = hydrogen, alkyl, substituted alkyl, phenyl or substituted phenyl, R₈, R₉, R₁₀ and R₁₁ being able to be identical or different and part of homo- or heterocyclic rings condensed on the thiophene ring.

7. Solution according to one of claims 5 and 6, **characterised in that** at least one thiophene is included from the group of aminothiophene carboxylic acids, esters thereof and amides thereof.

8. Solution according to one of claims 5 to 7, **characterised in that** at least one thiazol is included from the group of compounds having the chemical formula IV 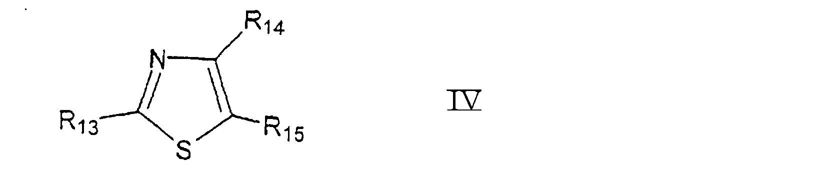
with R₁₃, R₁₄, R₁₅ = hydrogen, alkyl, substituted alkyl, phenyl, substituted phenyl, halogen, amino, alkylamino, dialkylamino, hydroxy, alkoxy, carboxy, carboxyalkyl, alkoxycarbonyl, aminocarbonyl, R₁₆-CONH- with R₁₆ = hydrogen, alkyl, substituted alkyl, phenyl or substituted phenyl, R₁₃, R₁₄, and R₁₅ being able to be identical or different and part of a homo- or heterocyclic ring condensed at the thiazol ring.

9. Solution according to one of claims 5 to 8, **characterised in that** at least one thiazol is included from the group of aminothiazols and substituted aminothiazols.

10. Solution according to one of claims 5 to 9, **characterised in that** at least one thiadiazol is included from the group of aminothiadiazols and substituted aminothiadiazols.

11. Solution according to one of the preceding claims, **characterised in that** at least one sulphonium salt is included from the group of trimethyl sulphonium salts, triphenyl sulphonium salts, methionine alkyl sulphonium salts and methionine benzyl sulphonium salts.

12. Solution according to one of the preceding claims, **characterised in that** at least one nitrogen-containing, five-membered, heterocyclic compound is included from the group of triazols, tetrazols, imidazols, pyrazols and purines.

13. Solution according to claim 12, **characterised in that** at least one triazol is included, having the chemical formula Va 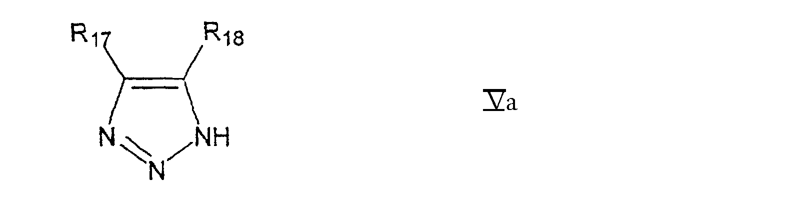
with R₁₇, R₁₈ = hydrogen, alkyl, substituted alkyl, amino, phenyl, substituted phenyl, carboxyalkyl, R₁₇ and R₁₈ being able to be identical or different and part of a homo- or heterocyclic ring condensed on the triazol ring.

14. Solution according to one of claims 12 and 13, **characterised in that** at least one triazol is included from the group of benzotriazol, methyl benzotriazol, ethyl benzotriazol and dimethyl benzotriazol.

15. Solution according to one of claims 12 to 14, **characterised in that** at least one tetrazol is included, having the chemical formula V6 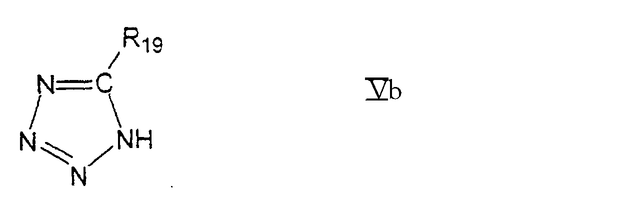
with R₁₉ = hydrogen, alkyl, substituted alkyl, halogen alkyl, amino, phenyl, substituted phenyl, benzyl, carboxy, carboxyalkyl, alkoxycarbonyl, aminocarbonyl, or R₂₀-CONH- with R₂₀ = hydrogen, alkyl, substituted alkyl, phenyl or substituted phenyl.

16. Solution according to one of claims 12 to 15, **characterised in that** at least one tetrazol is included from the group of 5-aminotetrazol and 5-phenyltetrazol.

17. Solution according to one of the preceding claims, **characterised in that** sulphuric acid is included as the acid for component b. in the solution.

18. Method for the preliminary treatment of copper surfaces for the subsequent formation of a firmly adhesive bonding between the copper surfaces and plastics material substrates, wherein the copper surfaces are brought into contact with the solution according to one of claims 1 to 17.

19. Use of the solution according to one of claims 1 to 17 for the preliminary treatment of printed circuit board inner layers, which have copper layers, for the formation of a firmly adhesive bonding between the printed circuit inner layers and synthetic resin layers.

20. Use of the solution according to one of claims 1 to 17 for the preliminary treatment of printed circuit boards, which have copper layers, for the formation of a firmly adhesive bonding between the copper layers and resists formed from plastics materials.

## Revendications

1. Solution de pré-traitement de surfaces de cuivre pour la formation postérieure d'une liaison par adhésion entre les surfaces de cuivre et des substrats de matière plastique, contenant
a. du peroxyde d'hydrogène,
b. au moins un acide et
c. au moins un composé hétérocyclique à cinq chaînons contenant de l'azote, qui ne contient pas d'atome de soufre, de sélénium ou de tellure dans l'hétérocycle,
**caractérisé en ce que**
d. en outre elle contient au moins un composé intermédiaire d'adhésion du groupe constitué par des acides sulfiniques, des acides séléniques, des acides telluriques, des composés hétérocycliques qui contiennent au moins un atome de soufre, de sélénium, et/ou de tellure dans l'hétérocycle, ainsi que des sels de sulfonium, sélénonium et telluronium, les composés de sulfonium, de sélénonium et de telluronium ayant la formule générale I 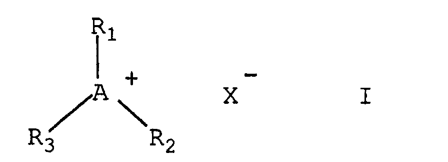 dans laquelle A = S, Se ou Te,
R₁, R₂ et R₃ = un groupe alkyle, alkyle substitué, alcényle, phényle, phényle substitué, benzyle, cycloalkyle, cycloalkyle substitué, où R₁, R₂ et R₃ sont identiques ou différents, et X⁻ = anion d'un acide minéral ou organique ou hydroxyde,
avec la condition que l'acide choisi pour le composant b. ne soit pas identique aux acides sulfiniques, séléniques ou telluriques choisis pour le composant d.

2. Solution selon la revendication 1, **caractérisée en ce que** sont contenus les acides sulfiniques du groupe constitué par les acides sulfiniques aromatiques et des composés ayant la formule chimique II 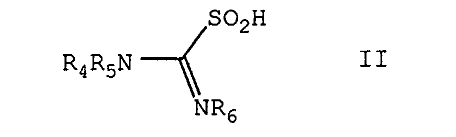
avec R₄, R₅ et R₆ = hydrogène, alkyle, alkyle substitué, phényle, phényle substitué, R₇-(CO), avec R₇ = hydrogène, alkyle, alkyle substitué, phényle ou phényle substitué, où R₄, R₅ et R₆ sont identiques ou différents.

3. Solution selon l'une des revendications précédentes, **caractérisée en ce que** l'acide formamidinesulfinique est contenu comme composé intermédiaire d'adhésion.

4. Solution selon l'une des revendications 1 et 2, **caractérisée en ce que** les acides sulfiniques aromatiques sont contenus dans le groupe constitué par l'acide benzènesulfinique, les acides toluènesulfiniques, les acides chlorobenzènesulfiniques, les acides nitrobenzène-sulfiniques et les acides carboxybenzènesulfiniques.

5. Solution selon l'une des revendications précédentes, **caractérisée en ce qu'**est contenu au moins un composé hétérocyclique intermédiaire d'adhésion du groupe constitué par les thiophènes, les thiazoles, les isothiazole, thiadiazoles et les thiatriazoles.

6. solution selon la revendication 5, **caractérisé en ce qu'**est contenu au moins un thiophène du groupe constitué par des composés ayant la formule chimique III 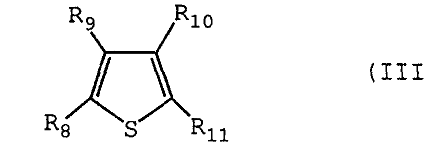
avec R₈, R₉, R₁₀, R₁₁ = hydrogène, alkyle, alkyle substitué, phényle, phényle substitué, halogène, amino, alkylamino, dialkylamino, hydroxy, alcoxy, carboxy, carboxyalkyle, alcoxycarbonyle, aminocarbonyle, R₁₂-CONH-, avec R₁₂ = hydrogène, alkyle, alkyle substitué, phényle ou phényle substitué, R₈, R₉, R₁₀ et R₁₁ étant identiques ou différents et pouvant être une partie de cycles homo- ou hétérocycliques condensés sur le cycle thiophène.

7. Solution selon l'une des revendications 5 et 6, **caractérisée en ce qu'**est contenu au moins un thiophène du groupe constitué par les acides aminothiophèncarboxyliques, leurs esters et leurs amides.

8. Solution selon l'une des revendications 5 à 7, **caractérisée en ce qu'**est contenu au moins un thiazole du groupe constitué par des composés ayant la formule chimique IV 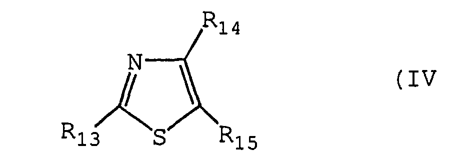
avec R₁₃, R₁₄, R₁₅ = hydrogène, alkyle, alkyle substitué, phényle, phényle substitué, halogène, amino, alkylamino, dialkylamino, hydroxy, alcoxy, carboxy, carboxyalkyle, alcoxy-carbonyle, R₁₆-CONH-, avec R₁₆ = hydrogène, alkyle, alkyle substitué, phényle ou phényle substitué, R₁₃, R₁₄ et R₁₅ étant identiques ou différents et pouvant être une partie de cycles homo- ou hétérocycliques condensés sur le cycle thiophène.

9. Solution selon l'une des revendications 5 à 8, **caractérisée en ce qu'**est contenu au moins un thiazole du groupe constitué par les aminothiazoles et les aminothiazoles substitués.

10. Solution selon l'une des revendications 5 à 9, **caractérisée en ce qu'**est contenu au moins un thiazole dugroupe constitué par les aminothiadiazoles et les aminothiadiazoles substitués.

11. Solution selon l'une des revendications précédentes, **caractérisée en ce qu'**est contenu au moins un sel de sulfonium du groupe constitué par les sels de triméthylsulfonium, les sels de triphénylsulfonium, les sels de méthioninealkylsulfonium et les sels de méthioninebenzylsulfonium.

12. Solution selon l'une des revendications précédentes, **caractérisée en ce qu'**est contenu au moins un composé hétérocyclique à cinq chaînons contenant de l'azote du groupe constitué par les triazoles, les tétrazoles, les imidazoles, les pyrazoles et les purines.

13. Solution selon la revendication 12, **caractérisée en ce qu'**est contenu au moins un triazole ayant la formule chimique Va 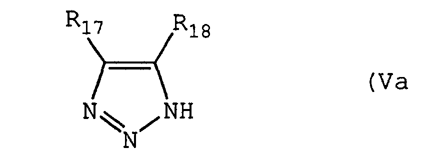
avec R₁₇, R₁₈ = hydrogène, alkyle, alkyle substitué, amino, phényle, phényle substitué, carboxyalkyle, où R₁₇ et R₁₈ sont identiques ou différents et peuvent être une partie d'un cycle homo- ou hétérocyclique condensé avec le cycle triazole.

14. Solution selon l'une des revendications 12 et 13, **caractérisée en ce qu'**est contenu au moins un triazole du groupe constitué par le benzotriazole, le méthylbenzotriazole, l'éthylbenzotriazole et le diméthylbenzotriazole.

15. Solution selon l'une des revendications 12 à 14, **caractérisée en ce qu'**est contenu au moins un tétrazole ayant la formule chimique Vb 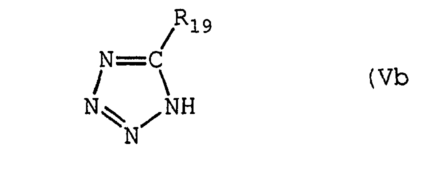
avec R₁₉ = hydrogène, alkyle, alkyle substitué, halogénoalkyle, amino, phényle, phényle substitué, benzyle, carboxy, carboxyalkyle, alcoxycarbonyle, amino-carbonyle ou R₂₀-CONH-, avec R₂₀ = hydrogène, alkyle, alkyle substitué, phényle ou phényle substitué.

16. Solution selon l'une des revendications 12 à 15, **caractérisé en ce qu'**est contenu au moins un térazole du groupe constitué par le 5-aminotétrazole et le 5-phényltétrazole.

17. Solution selon l'une des revendications précédentes, **caractérisée en ce que** l'acide sulfurique est contenu comme acide pour le composants b. dans la solution.

18. Procédé pour le pré-traitement de surfaces de cuivre pour la formation postérieure d'une liaison adhésive entre les surfaces de cuivre et des substrats de matière plastique, selon lequel on met en contact les surfaces de cuivre avec la solution selon l'une des revendications 1 à 17.

19. Utilisation de la solution selon l'une des revendications 1 à 17 pour le pré-traitement de couches internes de plaques conductrices présentant des couches de cuivre pour la formation d'une liaison adhésive entre les couches internes de plaques conductrices et des couches de résine.

20. Utilisation de la solution selon l'une des revendications 1 à 17 pour le pré-traitement de plaques conductrices présentant des couches de cuivre pour la formation d'une liaison adhésive entre les couches de cuivre et des résistances constituées par de la résine.
